# FASCICULE DE BREVET EUROPEEN

(11) **EP 2 963 674 B1**
(45) Date de publication et mention de la délivrance du brevet: **26.07.2023**
(21) Numéro de dépôt: 15174396.0
(22) Date de dépôt: 29.06.2015
(51) Int. Cl.: H01L 21/20, H01L 29/78, H01L 29/66

(54) **PROCÉDÉ DE RÉALISATION D'UN DISPOSITIF MICROÉLECTRONIQUE**
HERSTELLUNGSVERFAHREN EINER MIKROELEKTRONISCHEN VORRICHTUNG
METHOD FOR PRODUCING A MICROELECTRONIC DEVICE

(30) Priorité: 30.06.2014 FR 1456201
(43) Date de publication de la demande: 06.01.2016
(73) Titulaire: COMMISSARIAT À L'ÉNERGIE ATOMIQUE ET AUX ÉNERGIES ALTERNATIVES, 75015 Paris (FR)
(72) Inventeur: AUGENDRE, Emmanuel, 38330 Montbonnot (FR); BARON, Thierry, 38120 Saint-Egrève (FR)
(74) Mandataire: Hautier IP

(56) Documents cités:
- WO-A2-2010/033813
- US-A- 5 417 180
- US-A1- 2010 025 683
- US-A1- 2011 049 568
- US-A1- 2013 037 869
- US-A1- 2013 119 347
- US-A1- 2013 256 759
- VAN DAL MARK J H ET AL: "Germanium p-Channel FinFET Fabricated by Aspect Ratio Trapping", IEEE TRANSACTIONS ON ELECTRON DEVICES, IEEE, USA, vol. 61, no. 2, 1 February 2014 (2014-02-01), pages 430-436, XP011537687, ISSN: 0018-9383, DOI: 10.1109/TED.2013.2295883 [retrieved on 2014-01-20]

## Description

### DOMAINE DE L'INVENTION

La présente invention est relative aux procédés de réalisation des dispositifs pour la microélectronique. Elle concerne notamment les semi-conducteurs présentant de fortes mobilités (par exemple, à base de carbone, de germanium, d'alliages d'éléments du groupe III-V, ou de silicium contraint), pressentis comme alternatifs au silicium pour certaines applications dans les noeuds technologiques ultimes.

### ARRIERE-PLAN TECHNOLOGIQUE

Dans le domaine de la microélectronique, la diminution constante de la surface de silicium occupée par les composants a permis jusqu'à présent de maintenir la course à l'intégration à un rythme édicté par la loi de Moore, qui prévoit que le nombre de transistors par circuit intégré double tous les 18 à 24 mois environ. Cependant, cette course à l'intégration est sur le point de se heurter à des limites d'ordre physique et technologique que le transistor de type Métal-Oxide-Semiconducteur (« MOS ») sur silicium massif ne parviendra visiblement pas à surmonter. En outre, l'architecture sur silicium massif ne permettra pas de contenir, au-delà d'un certain seuil d'intégration, les efforts électrostatiques bi-dimensionnels et certains effets quantiques néfastes à l'effet de champ vertical induit par la grille. Les recherches actuelles en microélectroniques explorent ainsi de nouvelles architectures de composants, solutions alternatives au transistor « MOS » conventionnel. En outre, la mise au point d'architectures innovantes sur silicium mince en combinaison avec d'autres matériaux dits « exotiques » présentant de fortes mobilités (par exemple, à base de carbone, de germanium, d'alliages d'éléments du groupe III-V) pourrait permettre de continuer la course à la miniaturisation des composants de type « CMOS » (acronyme en anglais pour « Complementary Metal Oxide Semiconductor »).

Les dispositifs réalisés sur des matériaux de type semi-conducteur autres que le silicium sont le plus souvent obtenus à partir de couches épitaxiées sur des substrats massifs autres que le silicium (dont le diamètre est généralement inférieur ou égal à 200 millimètres). Ces substrats massifs autres que le silicium ont comme inconvénients leur coût et leur incompatibilité en taille avec les équipements développés pour les dernières générations de composants silicium (300 millimètres, 450 millimètres en préparation). L'emploi d'un substrat massif de silicium reste ainsi la solution la moins coûteuse et la plus compatible avec les procédés de fabrication connus.

Pour surmonter ces problèmes, a émergé la voie qui consiste à obtenir ces matériaux par croissance épitaxiale sur un substrat hôte de silicium de la taille souhaitée. Toutefois, cette approche se heurte à la forte disparité de paramètre de maille entre les principaux matériaux d'intérêt et le silicium. Par exemple, une différence de paramètres de maille proche de 4% est observée pour le germanium (Ge) et l'arséniure de gallium (GaAs) ; cette différence est d'environ 8% pour le phosphure d'indium (InP).

Dans ces conditions, obtenir une couche épitaxiale continue (sur tout le substrat hôte), comportant un minimum de défauts cristallins, impose de recourir à des couches tampon intermédiaires épaisses, rendant l'approche particulièrement coûteuse sans être complètement efficace. En effet, il reste toujours une densité non négligeable de dislocations.

En renonçant à l'obtention d'une couche continue, il est possible d'atteindre des densités de dislocations plus faibles pour des couches hétéro-épitaxiées sur un substrat de silicium. Ce principe est connu est anglais sous le terme de « aspect ratio trapping » ou encore « dislocations necking » qui pourrait être traduit en français par « piégeage par rapport de forme ».

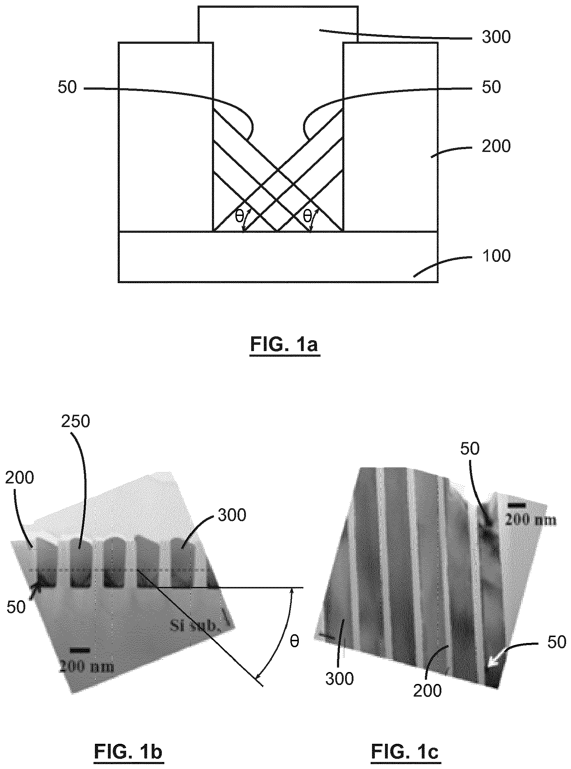

Néanmoins, cette approche a plusieurs limites. Ces inconvénients sont, par exemple, illustrés sur les figures 1a à 1c, provenant de la publication de J.-S. Park et al, Applied Physics Letter 90, 052113 (2007). La **figure 1a** illustre une représentation schématique du principe de confinement de dislocations 50 d'une couche 300 de germanium formée à partir d'un substrat 100 de silicium (Si) à l'intérieur d'une tranchée 250 formée dans une couche de masquage 200 à base d'oxyde de silicium (SiO₂). La croissance de la couche 300 de germanium se fait dans la tranchée 250 formée dans une couche de masquage 200 qui recouvre le substrat de silicium 100. Grâce à un rapport de forme minimum, les dislocations 50 se trouvent piégées sur les flancs et le fond de la couche 300, donnant un matériau de meilleure qualité en surface que l'équivalent en couche continue (pour la même épaisseur). Comme montré en figure 1a, les dislocations 50 transversales de la couche 300 de germanium nécessitent que la couche de masquage 200 ait une épaisseur supérieure à la largeur des tranchées 250.

En outre, un des inconvénients majeurs est l'émergence de dislocations 50 en surface qui n'est bloquée que dans les directions à fort rapport de forme c'est-à-dire selon une direction en transversale des tranchées 250 (voir la **figure 1b** illustrant une vue en coupe transversale, obtenue par microscopie électronique en transmission, « TEM ») mais pas dans la longueur (voir la **figure 1c** illustrant une vue de dessus, obtenue par microscopie électronique en transmission, « TEM »). Les dislocations 50 sont représentées par un contraste de couleur plus accentué sur les images TEM. On voit ainsi que les défauts cristallins (ou dislocations 50), engendrés par la croissance de la couche 300 à partir du substrat 100, sont localisés dans le fond de la tranchée 250, soit à l'interface avec le substrat 100, et le long des fla ncs de la couche de masquage 200. Le fort désaccord de paramètre de maille entre le substrat 100 et la couche 300 génère des défauts, plus communément appelés dislocations à l'interface. La déformation de la maille cristalline dans la couche supérieure modifie l'angle d'inclinaison des plans cristallins de ladite couche supérieure par rapport aux plans cristallins de la couche inférieure, formant un angle θ.

D'autre part, il peut être avantageux de faire croître un matériau contraint (c'est-à-dire dont le paramètre de maille dans une direction donnée est différent du paramètre de maille relaxé). Dans ce cas, il existe une limite appelée « épaisseur critique » au-delà de laquelle la croissance du matériau peut s'accompagner de la création de défauts cristallins et du relâchement de la contrainte. Si l'on souhaite réaliser des canaux contraints de type « fin » dans un matériau obtenu par croissance verticale, la hauteur des canaux « fins » est limitée par cette « épaisseur critique ».

De plus, l'obtention de motifs denses de la couche 300 de germanium est directement limitée par le pas de photo-répétition minimum. D'autre part, un inconvénient supplémentaire réside dans la largeur du canal épitaxié formé par la couche 300 de germanium qui subit directement les variations imposées par les étapes de formation des tranchées 250 ; lesdites tranchées 250 étant réalisées par photolithographie et/ou gravure, par exemple.

Le document WO2010033813 concerne la formation de dispositifs par croissance de couches épitaxiées.

Le document US2011049568 concerne la réalisation de dispositifs semi-conducteurs présentant un taux réduit de dislocations.

Le document US5417180 concerne la réalisation d'une structure de type silicium sur isolant.

Le document US2013119347 concerne la réalisation d'un dispositif semi-conducteur comprenant une barrière en matériau III-V.

Le document US2010025683 concerne une méthode pour réduire les effets de bord par piégeage par rapport de forme.

Le document US2013/0037869 concerne un procédé de fabrication d'un dispositif semiconducteur avec deux canaux.

Les documents suivants concernent la fabrication d'un FinFET :
- US2013/0256759,
- « Germanium p-Channel FinFET Fabricated by Aspect Ration Trapping », Mark J.H. van Dal et al. IEEE, Vol.61, N°2 février 2014.

Un objet de la présente invention consiste ainsi à proposer un procédé de réalisation d'au moins une structure cristalline qui limite, voire supprime, au moins certains des problèmes et inconvénients précédemment mentionnés concernant les solutions connues des techniques actuelles. Plus particulièrement, l'invention a pour objectif de former une structure cristalline, par exemple destinée à former un canal de transistor, en un matériau autre que celui du substrat, dépourvu ou présentant peu de défauts cristallins.

### RESUME DE L'INVENTION

L'invention concerne un procédé de réalisation selon la revendication 1.

Ainsi, la présente invention permet de réaliser de manière simple et reproductible, à partir d'un substrat cristallin formé en un premier matériau, au moins une couche épitaxiale cristalline en un deuxième matériau qui est selon un mode de réalisation avantageux différent du premier matériau du substrat.

L'invention permet de piéger les dislocations et autres défauts cristallins en partie inférieure de la couche tampon. La partie supérieure de cette dernière qui forme saillie au-delà de la couche de masquage est ainsi dépourvue de dislocations et autres défauts cristallins sur ses flancs latéraux. Cette partie supérieure sert ensuite de base à la croissance de la couche épitaxiale cristalline, elle aussi dépourvue de dislocations et autres défauts cristallins, pouvant engendrer des dysfonctionnements dans un dispositif microélectronique.

L'invention permet aussi de former des couches épitaxiales contraintes lors de la phase de croissance latérale, dont la dimension verticale dépasse l'épaisseur critique de croissance, grâce au fait que la dernière croissance se fait de façon latérale et non de façon verticale (l'épaisseur critique se mesurant de façon latérale et non plus verticale).

La couche épitaxiale cristalline ainsi formée est par exemple destinée à former un canal.

L'invention offre ainsi une solution simple, précise et efficace pour former des couches cristallines dans un matériau donné à partir d'un substrat massif cristallin fait d'un matériau différent.

Un mode de réalisation non compris dans l'invention revendiquée concerne également un dispositif microélectronique comprenant un substrat cristallin recouvert d'une couche de masquage comprenant au moins une tranchée formant un accès au substrat, la tranchée présentant une profondeur au moins égale à sa largeur, caractérisé en ce qu'il comprend :
- une couche tampon cristalline formée au moins en partie dans la tranchée et s'étendant depuis le substrat pour former saillie par rapport à la couche de masquage ;
- une couche épitaxiale cristalline formée au moins sur une partie des flancs latéraux de la couche tampon qui forme saillie au-delà de la couche de masquage.

Ainsi, est réalisé un dispositif selon un procédé qui, de manière particulièrement avantageuse, n'est pas sujet aux limitations rencontrées sur les substrats massifs, et notamment au choix du matériau et au rapport de forme.

Facultativement, le matériau de la couche épitaxiale est choisi de sorte à être apte à croître sur le matériau de la couche tampon. Optionnellement, le matériau de la couche tampon est choisi selon l'orientation des plans cristallins du substrat. Selon l'invention revendiquée, le matériau de la couche tampon est différent du matériau de la couche épitaxiale de sorte à pouvoir retirer de manière sélective la couche tampon vis-à-vis de la couche épitaxiale.

Selon l'invention revendiquée, chaque couche épitaxiale forme un canal d'un transistor, par exemple de type FinFET sans que cela soit limitatif.

Selon l'invention revendiquée, la couche épitaxiale formant deux portions s'étendant de part et d'autre de la couche tampon, chaque portion de la couche épitaxiale formant un canal d'un transistor, de préférence de type FinFET. Ainsi une portion située d'un côté de la couche tampon forme un premier canal et une portion située de l'autre côté de la couche tampon forme un deuxième canal.

Selon un mode de réalisation non compris dans l'invention revendiquée, on forme un canal sur l'un seulement des flancs latéraux de la couche tampon. Selon l'invention revendiquée, on forme un canal sur chacun des flancs latéraux de la couche tampon, formant ainsi une paire de canaux à partir d'une même couche tampon. La formation de paires de canaux apporte un avantage en termes de densité (deux fois plus de canaux). Cela permet de former des structures verticales avec peu de limitations en termes de densité.

Selon l'invention revendiquée, les canaux sont isolés électriquement.

De manière particulièrement avantageuse, le procédé selon la présente invention permet de réaliser un dispositif présentant au moins un canal défini par (hétéro-)épitaxie. Avantageusement, l'au moins un canal forme un canal mince grâce à une croissance latérale contrôlée ; la ligne formée par ledit canal étant de ce fait mieux contrôlée en épaisseur et présentant moins de rugosité.

Les canaux obtenus peuvent ainsi présenter une épaisseur très fiable, épaisseur prise dans un plan parallèle au plan dans lequel s'étend principalement le substrat.

### BREVE INTRODUCTION DES FIGURES

D'autres caractéristiques, buts et avantages de la présente invention apparaitront à la lecture de la description détaillée qui suit, en regard des dessins annexés, donnés à titre d'exemples, non limitatifs, et sur lesquels :
La FIGURE 1a illustre une représentation schématique du principe de confinement des dislocations d'une couche de germanium formée à partir d'un substrat de silicium à l'intérieur d'une tranchée à base d'oxyde de silicium.
La FIGURE 1b illustre une vue en coupe transversale, obtenue par microscopie électronique en transmission, du principe de confinement des dislocations d'une couche de germanium formée à partir d'un substrat de silicium à l'intérieur d'une tranchée à base d'oxyde de silicium.
La FIGURE 1c illustre une vue de dessus, obtenue par microscopie électronique en transmission, du principe de confinement des dislocations d'une couche de germanium formée à partir d'un substrat de silicium à l'intérieur d'une tranchée à base d'oxyde de silicium.
Les FIGURE 2a à 2f illustrent la formation d'une couche cristalline selon un premier mode de réalisation de l'invention. Plus précisément :

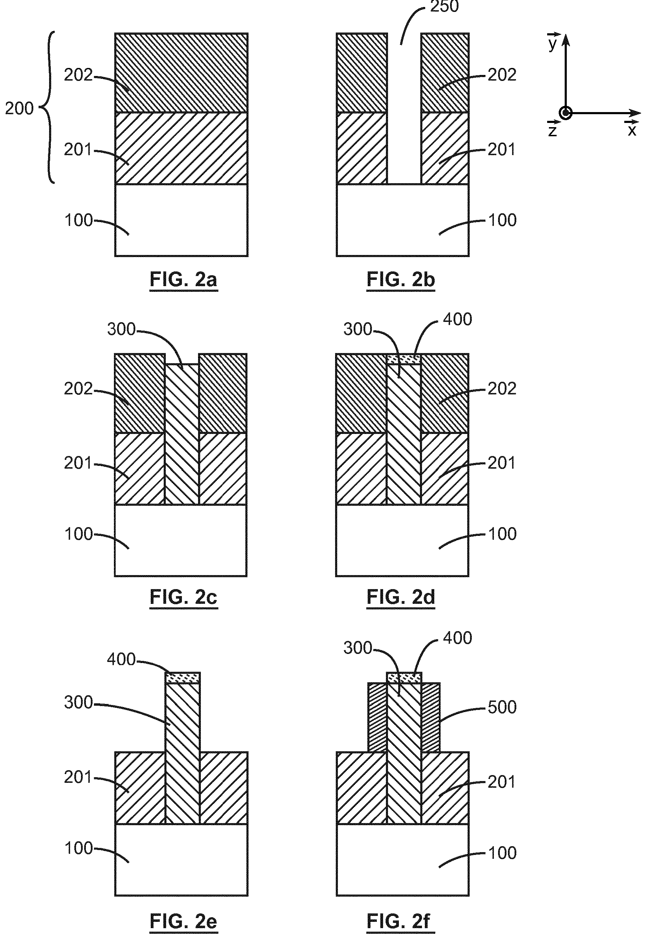

   La FIGURE 2a illustre la formation d'une couche de masquage sur le substrat ; ladite couche de masquage comprenant une pluralité de couches.
La FIGURE 2b illustre la formation d'une tranchée dans la couche de masquage de façon à former une ouverture d'accès dans le substrat.
La FIGURE 2c illustre la formation d'une couche tampon dans la tranchée de la couche de masquage.
La FIGURE 2d illustre la formation d'une couche de protection au moins sur la face supérieure de la couche tampon.
La FIGURE 2e illustre le retrait sélectif partiel de la couche de masquage de sorte à ce que la couche tampon fasse saillie au-delà de la couche de masquage, laissant à découvert au moins la face supérieure et une partie des flancs latéraux de la couche tampon.
La FIGURE 2f illustre la formation de la couche épitaxiale sur au moins la partie des flancs latéraux de la couche tampon laissés à découvert.

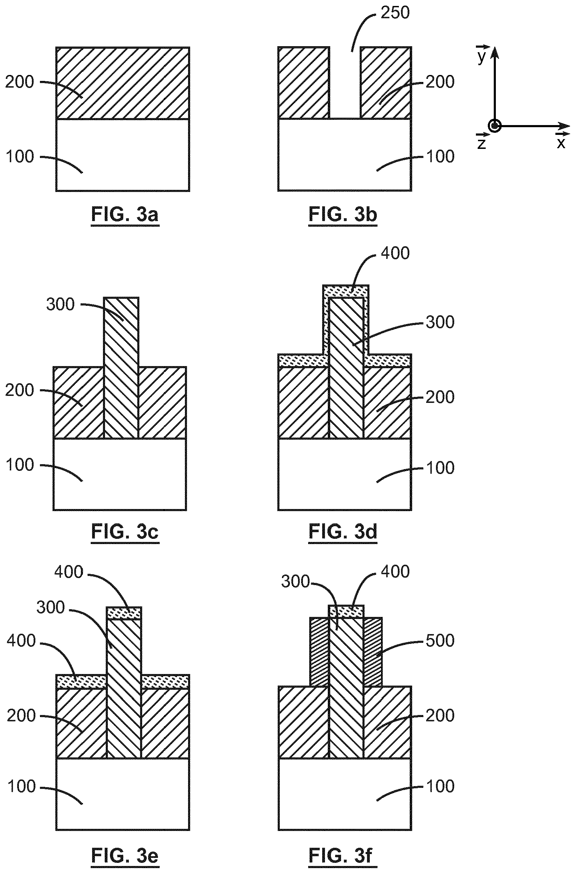

Les FIGURE 3a à 3f illustrent la formation d'une couche cristalline selon un deuxième mode de réalisation non compris dans l'invention revendiquée. Plus précisément :
   La FIGURE 3a illustre la formation d'une couche de masquage sur un substrat.
La FIGURE 3b illustre la formation d'une tranchée dans la couche de masquage de façon à former une ouverture d'accès dans le substrat.
La FIGURE 3c illustre la formation d'une couche tampon dans la tranchée de la couche de masquage.
La FIGURE 3d illustre la formation d'une couche de protection sur les couches.
La FIGURE 3e illustre le retrait partiel de la couche de protection de sorte à découvrir les flancs latéraux de la couche tampon.
La FIGURE 3f illustre la formation de la couche épitaxiale sur au moins la partie des flancs latéraux de la couche tampon laissés à découvert.

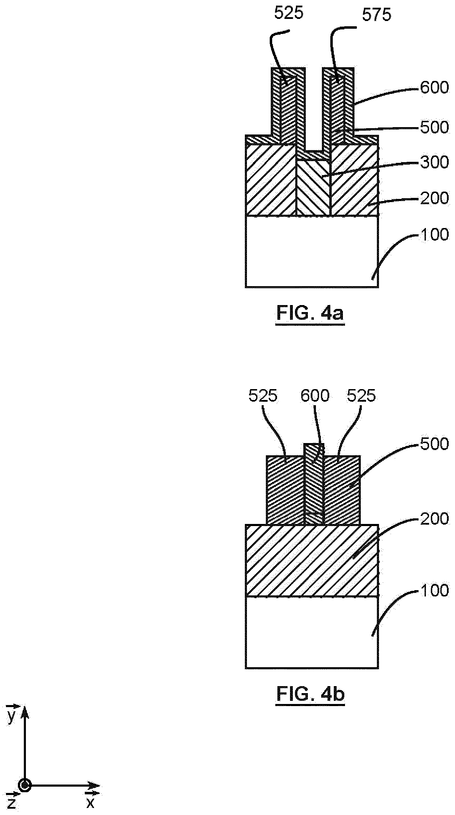

Les FIGURES 4a et 4b illustrent respectivement une vue de face et une vue de profil d'un dispositif comprenant un transistor de type finFET réalisé à partir d'une couche épitaxiale formée selon le procédé de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches ne sont pas représentatives de la réalité.

Il est précisé que dans le cadre de la présente invention, le terme « sur » ne signifie pas obligatoirement « au contact de ». Ainsi, par exemple, la formation d'une couche sur une autre couche, ne signifie pas obligatoirement que les deux couches sont directement au contact l'une de l'autre mais cela signifie que l'une des couches recouvre au moins partiellement l'autre en étant soit directement à son contact, soit en étant séparée d'elle par un film, encore une autre couche ou un autre élément.

### DESCRIPTION DETAILLEE

Avant d'entamer une revue détaillée de modes de réalisation de l'invention, sont énoncées ci-après des caractéristiques optionnelles qui peuvent éventuellement être utilisées en association ou alternativement. Les exemples qui ne rentrent pas dans la portée des revendications de protection ne font pas partie de l'invention.

On rappelle tout d'abord que l'invention porte sur un procédé de réalisation d'une couche cristalline à partir d'un substrat cristallin.

Préférentiellement, la croissance de la couche tampon comprend une croissance épitaxiale à partir du substrat. De manière particulièrement avantageuse, la croissance épitaxiale permet d'obtenir une couche dont le matériau est de meilleure qualité cristalline, comprenant de ce fait un nombre réduit de dislocations. Les techniques de croissance épitaxiale sont de préférence choisies parmi les techniques de dépôt chimique en phase vapeur (ou CVD pour l'anglais « chemical vapor deposition ») ou de l'épitaxie par jet moléculaire (ou MBE pour l'anglais « molecular beam epitaxy ») ; ces techniques étant couramment utilisées en industrie.

Selon une alternative, la croissance de la couche tampon comprend un dépôt de ladite couche, suivi d'un recuit de cristallisation. Pour ce type de dépôt, le dépôt chimique en phase vapeur pourra avantageusement être utilisé.

De manière générale, la couche tampon cristalline est formée par croissance à partir du germe du substrat cristallin.

Ainsi ladite étape de formation de la couche tampon comprend une croissance de la couche tampon en en utilisant comme germe le germe du substrat cristallin. L'utilisation du germe du substrat cristallin permet de donner à la couche tampon une structure cristalline qui peut être identique ou différente de celle du substrat.

Avantageusement, la couche de masquage, en particulier son matériau et sa structure, est choisie de manière à empêcher la croissance de la couche épitaxiale à partir de la couche de masquage. Cela permet avantageusement une croissance sélective des différentes couches.

Selon l'invention, la formation de la couche tampon est effectuée de manière à laisser à découvert une face supérieure de la couche tampon en plus de ladite partie supérieure des flancs latéraux de la couche tampon et, préalablement à la formation de la couche épitaxiale, on réalise la formation d'une couche de protection sur ladite face supérieure de la couche tampon de sorte à laisser découvert uniquement ladite partie supérieure des flancs latéraux de la couche tampon laissée à découvert. Avantageusement, la couche de protection permet une croissance sélective uniquement sur les flancs latéraux de la couche tampon. Ainsi, la couche de protection permet d'éviter qu'une croissance épitaxiale ne s'effectue à partir du sommet de la couche tampon. Cette croissance épitaxiale s'effectue ainsi uniquement latéralement à partir des flancs de la couche tampon.

Préférentiellement, la couche de protection, en particulier son matériau et sa structure, est choisie de manière à empêcher la croissance de la couche épitaxiale à partir de la couche de protection.

De manière particulièrement avantageuse, la formation de la couche épitaxiale comprend une croissance épitaxiale à partir de la partie supérieure des flancs latéraux de la couche tampon laissée à découvert. La croissance épitaxiale permet avantageusement de former une couche de bonne qualité cristalline présentant une faible densité de dislocations.

Selon un mode de réalisation, la formation de la couche épitaxiale comprend une croissance anisotrope dirigée perpendiculairement aux flancs latéraux de la couche tampon laissée à découvert. Avantageusement, cette croissance anisotrope permet de former des canaux de faible largeur et présentant une faible densité de dislocations et autres défauts cristallins.

Selon un autre mode de réalisation, la formation de la couche épitaxiale comprend un dépôt de matériau amorphe suivi d'une étape de cristallisation dudit matériau. Avantageusement, ce mode de réalisation est utilisé pour la formation de couches épitaxiales ne comportant que des éléments de la colonne IV du tableau périodique des éléments en alliage éventuel (par exemple, le carbone, le silicium, le germanium, l'étain). Optionnellement, l'étape de cristallisation sera suivie d'une étape de retrait d'une zone amorphe ou polycristalline résiduelle, par exemple réalisée par gravure anisotrope.

Selon l'invention, la formation de la couche tampon formant saillie au-delà de la première couche de la couche de masquage comprend, après la croissance de la couche tampon à partir du substrat, une étape de retrait d'une partie de la couche de masquage de sorte à découvrir ladite partie supérieure des flancs latéraux de la couche tampon.

Selon un mode de réalisation, la croissance de la couche tampon à partir du substrat est effectuée de manière à ce que le sommet de la couche tampon ne forme pas saillie au-delà de la couche de masquage avant l'étape de retrait d'une partie de la couche de masquage et forme saillie au-delà de la couche de masquage après l'étape de retrait d'une partie de la couche de masquage.

Selon l'invention, l'étape de retrait d'une partie de la couche de masquage est effectuée par gravure. Préalablement à l'étape de retrait d'une partie de la couche de masquage, on réalise la formation d'une couche de protection sur la face supérieure de la couche tampon et la gravure de la couche de masquage grave la couche de masquage sélectivement à la couche de protection et à la couche tampon.

Selon un mode de réalisation, on conserve la couche de protection lors de la formation de la couche épitaxiale.

Selon un mode de réalisation non compris dans l'invention revendiquée, la couche de masquage est formée d'une seule couche.

Selon l'invention, la couche de masquage (200) est formée d'un empilement de couches.

Selon l'invention, la couche de masquage comprend un empilement de couches dont les matériaux diffèrent d'une couche à l'autre et sont configurés de sorte à être retirés sélectivement les uns par rapport aux autres.

Selon l'invention, la couche de masquage comprend une première couche formant une couche d'arrêt surmontée d'au moins une deuxième couche. L'étape de retrait d'une partie de la couche de masquage est effectuée par gravure de la deuxième couche et la gravure de la deuxième couche s'effectue avec arrêt sur la première couche.

Selon un mode de réalisation, la croissance épitaxiale de la couche tampon dépend de l'orientation des plans cristallins du substrat.

Selon un mode de réalisation, la cinétique de gravure de la deuxième couche est supérieure à au moins deux fois la cinétique de gravure de la première couche. Ainsi, la première couche forme une couche d'arrêt pour la gravure de la deuxième couche.

Selon un mode de réalisation non compris dans l'invention revendiquée, l'étape de retrait d'une partie de la couche de masquage est effectuée par gravure et l'étape de retrait d'une partie de la couche de masquage est effectuée en contrôlant le temps de gravure.

Selon l'invention, la croissance de la couche tampon à partir du substrat est poursuivie jusqu'à ce que la couche tampon forme saillie au-delà de la couche de masquage.

Selon un mode de réalisation, la formation d'une couche de protection sur ladite face supérieure de la couche tampon comprend :
- le dépôt d'une couche de protection sur le dispositif ;
- le retrait de la totalité de la couche de protection sur les flancs latéraux de la couche tampon tout en conservant une partie au moins de la couche de protection sur la couche de masquage et sur ladite face supérieure de la couche tampon ;
- le retrait de la couche de protection sur la couche de masquage en laissant en place la couche de protection sur ladite face supérieure de la couche tampon.

Selon un mode de réalisation non compris dans l'invention revendiquée, la couche tampon est faite d'un matériau identique à celui de la couche épitaxiale.

Selon l'invention, la couche tampon est faite d'un matériau différent de celui de la couche épitaxiale.

Selon l'invention, le matériau de la couche tampon (300) et le matériau de la couche épitaxiale présentent un désaccord de paramètre de maille inférieur à 2%.

Selon un mode de réalisation, la couche tampon est faite d'un matériau différent de celui du substrat.

Selon un mode de réalisation, le matériau de la couche tampon et le matériau du substrat présentent un désaccord de paramètre de maille inférieur à 10%.

Selon un mode de réalisation, une couche interfaciale isolante électriquement est déposée entre le substrat et la couche de masquage.

Selon un mode de réalisation, le substrat est en silicium ou un alliage de silicium et d'un autre matériau et le matériau de la couche tampon est un matériau semi-conducteur, de préférence pris parmi : un alliage de germanium-silicium (Si-Ge), l'arséniure de gallium (GaAs), le germanium (Ge), l'arséniure d'indium-gallium (InGaAs), le phosphure d'indium (InP), le nitrure de gallium (GaN), le nitrure d'aluminium (AIN) ou un alliage de ces matériaux.

Selon un mode de réalisation, le substrat est en silicium ou un alliage de silicium et d'un autre matériau et le matériau de la couche épitaxiale est un matériau semi-conducteur, de préférence pris parmi : un alliage de germanium-silicium (Si-Ge), l'arséniure de gallium (GaAs), le germanium (Ge), l'arséniure d'indium-gallium (nGaAs), le phosphure d'indium (InP), le nitrure de gallium (GaN), le nitrure d'aluminium (AIN) ou un alliage de ces matériaux.

Selon un mode de réalisation, les matériaux de la couche tampon et de la couche épitaxiale sont choisis parmi les combinaisons suivantes : un alliage de germanium-silicium (Si-Ge) avec du silicium (Si), un alliage de germanium-silicium-étain (Si-Ge-Sn) avec un alliage de silicum germanium (Si-Ge), de l'arséniure de gallium (GaAs) avec du germanium (Ge), de l'arséniure d'indium-gallium (InGaAs) avec du phosphure d'indium (InP), du nitrure de gallium (GaN) avec du nitrure d'aluminium (AIN).

Selon un mode de réalisation, la largeur de chacune des couches épitaxiale formées de part et d'autre de la couche tampon est comprise entre 5nm et 150nm, la largeur étant mesurée dans une direction perpendiculaire aux flancs latéraux.

Selon un mode de réalisation, la couche de masquage isole électriquement la couche épitaxiale du substrat.

Selon un mode de réalisation, on réitère l'étape de formation de la couche épitaxiale de sorte à ce que la couche épitaxiale soit formée d'un empilement de couches présentant des matériaux différents ou identiques. Avantageusement, cette séquence permet par exemple d'obtenir un canal et une couche tampon (couche intercalaire entre le canal et l'isolant de grille) dans la même étape de croissance.

La tranchée présente une profondeur au moins égale à une valeur Hc telle que Hc= K.S.tan(θ) où K est au moins supérieur à 0.7, S est la largeur de la tranchée et θ est l'angle des dislocations par rapport au plan du substrat.
Selon un mode de réalisation, K est supérieur à 0.8 et de préférence supérieur ou égal à 1. Avantageusement K =1. Cela permet de cantonner efficacement les dislocations dans la tranchée.

Lorsqu'une couche supérieure est formée, de préférence par croissance, à partir d'une couche inférieure ; lesdites couches inférieure et supérieure n'ayant pas le même paramètre de maille, le fort désaccord de paramètre de maille entre les couches génère des défauts, plus communément appelés dislocations à l'interface. La déformation de la maille cristalline dans la couche supérieure modifie l'angle d'inclinaison des plans cristallins de ladite couche supérieure par rapport aux plans cristallins de la couche inférieure. On entend ainsi par angle de dislocations θ, l'angle d'inclinaison des plans cristallins de la couche supérieure par rapport à la couche inférieure. De manière générale, l'angle de dislocations θ peut être, par exemple, déterminé par microscopie électronique en transmission.
L'angle de dislocations θ est avantageusement compris entre 30° et 90°, et préférentiellement compris entre 50° et 60°. Selon un mode de réalisation, la valeur Hc est comprise entre 0.5S et 2.5S, de préférence comprise entre S et 2.5S. A titre préféré, la valeur Hc est de l'ordre de 2S.

Avantageusement, le rapport d'aspect est de l'ordre de 2. Selon un mode préféré, la tranchée présente une profondeur supérieure à 2 fois et de préférence supérieure à 3 fois la largeur de la tranchée.

Selon l'invention, chaque couche épitaxiale forme un canal d'un transistor.

Les **figures 2a** à **2f** détaillent les étapes du procédé de l'invention selon un premier mode de réalisation.

La **figure 2a** illustre la formation d'une couche de masquage 200 sur un substrat 100. Le procédé de fabrication est réalisé à partir d'un substrat 100, en un premier matériau, de préférence à base de semi-conducteur. Avantageusement, la coupe du substrat 100, c'est-à-dire l'orientation de la surface de ce cristal semi-conducteur, dépend de l'application envisagée. Selon des exemples de réalisation non limitatifs de l'invention, on peut choisir un substrat 100, de préférence de silicium, dont la surface du cristal est orientée soit selon les plans cristallins <100>, soit selon les plans cristallins <100> mais désaxés de quelques degrés, ou soit selon les plans cristallins <111>.

Le procédé débute par la formation d'une couche de masquage 200 sur le substrat 100. La couche de masquage 200 est choisie de préférence électriquement isolante. La couche de masquage 200 comprend un empilement de couches 201, 202. Les couches 201, 202 sont formées à partir de matériaux possédant des sélectivités de gravures différentes. Les matériaux des couches 201, 202 sont choisis de sorte à ce qu'il soit possible de graver sélectivement une deuxième couche 202 par rapport à une première couche 201. Selon un exemple de réalisation, la sélectivité de la gravure entre ces première et deuxième couches 201 et 202 peut être de 4 pour 1, de sorte que la première couche 201 soit consommée 4 fois plus lentement que la deuxième couche 202.

L'épaisseur de la couche de masquage 200 (ou de l'empilement de couches 201, 202) est typiquement comprise entre 200 nanomètres (nm) et 1 micron (µm = 10⁻⁶ mètres). L'épaisseur est mesurée selon une direction perpendiculaire à la surface principale du substrat 100.

La surface du substrat 100 s'étend principalement dans un plan parallèle au plan ZX du repère orthogonal illustré en figure 2b. Ainsi, dans la présente demande de brevet les épaisseurs sont généralement prises selon la direction Y perpendiculaire à la face principale du substrat sur lequel repose les différentes couches. Sur les figures, l'épaisseur est prise selon la verticale.

Selon un exemple de réalisation, on insère une couche supplémentaire (non illustrée) entre le substrat 100 et la couche de masquage 200 (ou la première couche 201). Cette couche supplémentaire est configurée de sorte à servir de couche d'arrêt lors d'une éventuelle gravure de la couche de masquage 200 (ou la première couche 201) et ainsi à faciliter ladite gravure, sans entrainer de dommage pour le substrat 100.

La **figure 2b** illustre la formation de tranchées 250 dans la couche de masquage 200 (c'est-à-dire l'empilement des couches 201, 202) de façon à atteindre le substrat 100. Selon un mode de réalisation, les tranchées 250 sont obtenues par une gravure sélective de la couche de masquage 200 (ou de l'empilement de couches 201, 202). La gravure est préférentiellement anisotropique. La gravure est réalisée de sorte à former des tranchées 250 dont les parois, s'étendant selon une direction perpendiculaire à la surface du substrat 100 (direction Y), comprennent les flancs latéraux de la couche de masquage 200 ou les flancs latéraux des première et deuxième couches 201, 202, selon le mode de réalisation choisi. Ces tranchées 250 présentent un rapport de forme avantageusement supérieur à 1.

On entend par rapport de forme, le rapport entre la profondeur et la largeur de la tranchée 250. La profondeur de la tranchée 250 s'étend selon une direction perpendiculaire à la surface du substrat 100. Elle est prise selon la direction Y. La largeur de la tranchée 250 est la distance séparant les parois opposées de la tranchée 250 et s'étend selon un plan parallèle à la surface du substrat 100. Elle est prise selon la direction X.

Avantageusement, la profondeur de la tranchée 250 correspond à l'épaisseur de la couche de masquage 200. La profondeur de la tranchée 250 est typiquement comprise entre 50 nm et 1 µm. L'épaisseur de la tranchée 250 est de préférence comprise entre 20 nm et 400 nm. De manière particulièrement avantageuse, la profondeur de la tranchée 250 est au moins égale à la largeur de la tranchée 250.

La **figure 2c** illustre l'étape de formation de la couche tampon 300 dans la tranchée 250 formée dans la couche de masquage 200. Préférentiellement, la formation de la couche tampon 300 comprend une croissance épitaxiale de ladite couche tampon 300, à partir du substrat 100. On entend par croissance épitaxiale la formation d'une couche cristalline de même orientation au contact direct du substrat germe 100. La formation peut avantageusement avoir la forme d'une croissance par jet moléculaire (« MBE » an anglais pour « molecular beam epitaxy ») ou en phase vapeur (« CVD » en anglais pour « chemical vapor deposition »). Elle pourrait aussi être obtenue par une succession d'étapes mettant en jeu le dépôt d'une couche amorphe, sa cristallisation au contact du substrat germe 100 et le retrait du matériau déposé indésirable. Si le matériau de la couche tampon 300 possède un paramètre de maille différent de celui du substrat 100 alors il possède de préférence une structure cristalline et un paramètre de maille compatibles avec les propriétés cristallines de la surface du substrat 100. Quant aux matériaux de l'empilement de couches 201, 202, ils sont avantageusement compatibles avec les conditions de formation du matériau de la couche tampon 300.

Selon un exemple de configuration, dans l'objectif de faire croître un alliage de silicium-germanium (SiGe) pour la couche tampon 300, on utilisera préférentiellement une surface du substrat 100 orientée selon les plans cristallins <100>. Pour faire croître de l'arséniure de gallium (GaAs) pour la couche tampon 300, on utilisera de préférence une surface du substrat 100 orientée selon les plans cristallins <100>, mais légèrement désorientée (selon un angle inférieur à 10 degrés). Dans un autre cas, pour une croissance de nitrure de gallium (GaN) pour la couche tampon 300, on utilisera préférentiellement une surface du substrat 100 orientée selon les plans cristallins <111>.

Avantageusement, la largeur de la tranchée 250 ainsi que l'épaisseur de la couche de masquage 200 comprenant, selon un mode de réalisation, une première couche 201 et une deuxième couche 202, sont choisies de sorte à ce que les défauts cristallins (soit les dislocations 50 observées dans les figures 1a à 1c) de la couche tampon 300, soient confinés sur les flancs latéraux de la première couche de masquage 201 sans atteindre les flancs latéraux de la deuxième couche 202 isolante.

Selon des exemples de réalisation non limitatifs de l'invention, le matériau de la couche de masquage 200 (ou de la première couche 201) peut être choisi parmi l'oxyde de silicium (SiO₂) ou bien le nitrure de silicium (Si₃N₄) dans le cas où la couche tampon 300 comprend un matériau de type tel que l'arséniure de gallium (GaAs), l'alliage de silicium-germanium-étain (SiₓGe_{1-X-Y}Sn_{Y}, où x et y sont les proportions relatives de silicium et d'étain dans le matériau, avec x+y compris entre 0 et 1) ou le phosphure d'indium (InP). Dans le cas d'une croissance de nitrure de gallium (GaN), on pourra utiliser le nitrure de silicium (Si₃N₄) comme matériau pour la couche de masquage 200.

A l'issue de la croissance, la couche tampon 300 est en partie confinée dans la tranchée 250 ; ses bords latéraux étant encadrés par les parois de la tranchée 250, sa face inférieure étant au contact du substrat 100.

Selon le mode de réalisation illustré, la croissance de la couche tampon est stoppée avant que la hauteur de la couche tampon (prise selon la direction Y) ne dépasse la profondeur de la tranchée 250. La face supérieure de la couche tampon, représentant le sommet de cette couche 300 est non recouverte. Les faces supérieure et inférieure de la couche tampon 300 s'étendent selon un plan sensiblement parallèle à la surface du substrat 100.

La **figure 2d** illustre la formation d'une couche de protection 400 sur au moins la face supérieure de la couche tampon 300. Selon un mode de réalisation préférentiel mais non limitatif, la formation de la couche de protection 400 est réalisée en « pleine plaque » c'est-à-dire sur toute la surface. Cette étape sera préférentiellement suivie d'un retrait partiel de la couche de protection 400 de sorte à ne laisser en place la couche de protection 400 que sur la face supérieure de la couche tampon 300 comme illustré en figure 2d.

Ce retrait partiel comprend, par exemple, une planarisation effectuée par un polissage mécano-chimique. La couche de protection 400 peut être formée par une technique de déposition ou par une technique de croissance. Selon un autre mode de réalisation, la couche de protection 400 est formée uniquement sur la face supérieure de la couche tampon 300 par le recours à des techniques de photolithographie et de gravure, par exemple. Le matériau de la couche de protection 400 est avantageusement choisi tel qu'il puisse ralentir voire bloquer une éventuelle croissance épitaxiale sur la face supérieure de la couche tampon 300. De plus, ce matériau est également choisi de sorte à résister au retrait sélectif de la deuxième couche 202 (c'est-à-dire la couche supérieure de l'empilement de la couche de masquage 200). Le matériau de la couche de protection 400 est, par exemple, de l'oxyde d'aluminium (Al₂O₃) dans le cas où le matériau de la couche tampon 300 est choisi parmi l'oxyde de silicium (SiO₂) ou le nitrure de silicium (Si₃N₄).

La **figure 2e** illustre le retrait partiel sélectif de la couche de masquage 200 soit le retrait sélectif de la deuxième couche 202 de masquage. Selon un mode de réalisation particulièrement avantageux, le retrait de la deuxième couche 202 comprend une gravure pouvant être isotrope ou anisotrope et qui peut être réalisée à l'aide d'une solution aqueuse d'acide fluorhydrique dans le cas où la couche 200 est réalisée en dioxyde de silicium (SiO₂) et la couche 300 est un semi-conducteur cristallin de sorte à ce que le retrait s'effectue selon une direction parallèle aux flancs latéraux de la couche tampon 300 ; lesdits flancs latéraux n'étant de ce fait que faiblement attaqués lors de cette étape de retrait de la deuxième couche 202 isolante.

Dans le cas où le procédé nécessiterait le retrait sélectif de la couche de protection 400 relativement aux couches isolantes 200, 202 : si la couche de protection 400 comprend de l'alumine (Al₂O₃) et les couches de masquage 200, 202 de l'oxyde de silicium (SiO₂) et/ou du nitrure de silicium (Si₃N₄), alors la solution de gravure pourrait être formée à partir d'un mélange comprenant de l'acide sulfurique (H₂SO₄) et de peroxyde d'hydrogène (H₂O₂) ou d'hydroxyde de potassium (KOH). Dans le cas où le procédé nécessiterait le retrait sélectif de la deuxième couche 202 de masquage relativement à la couche de protection 400 et à la première couche 201 de masquage : si la deuxième couche 202 de masquage comprend du nitrure de silicium (Si₃N₄), la couche de protection 400 de l'alumine (Al₂O₃) et la première couche 201 de masquage de l'oxyde de silicium (SiO₂), alors la solution de gravure pourrait être formée à partir d'un mélange comprenant du trifluorométhane (CHF₃) et du dioxygène (O₂). Dans un autre cas où la deuxième couche 202 isolante comprend de l'oxyde de silicium (SiO₂), la couche de protection de l'alumine (Al₂O₃) et la couche de masquage 201 du nitrure de silicium (Si₃N₄), alors la solution de gravure de la couche de masquage 202 pourrait être formée à partir d'acide fluorhydrique (HF).

A l'issue de ce retrait partiel sélectif de la couche de masquage 200, la couche tampon 300 forme avantageusement saillie au-delà de la couche de masquage 200. La couche tampon 300 laisse ainsi à découvert au moins une partie supérieure de ses flancs latéraux ; lesdits flancs latéraux s'étendant selon un plan orthogonal à la surface du substrat 100 (donc dans un plan YZ). Préférentiellement, la hauteur (mesurée selon une direction Y orthogonale à la surface du substrat) est de 5 à 150 nm de la partie de la couche tampon 300 faisant saillie au-delà de la couche de masquage 200 correspond à l'épaisseur de la deuxième couche 202 de masquage retirée lors de l'étape de retrait de ladite couche. La première couche 201 de masquage fait office de couche d'arrêt lors du retrait de la deuxième couche 202 de masquage.

La **figure 2f** illustre l'étape de formation de la couche épitaxiale 500 sur les flancs latéraux de la couche tampon 300, flancs laissés à découvert lors de la précédente étape. Avantageusement, la formation de la couche épitaxiale 500 comprend une croissance latérale réalisée par jet moléculaire (acronyme MBE en anglais) ou en phase vapeur (acronyme CVD en anglais), selon une direction perpendiculaire aux flancs de la couche tampon 300 (donc selon la direction X), de la couche épitaxiale 500 à partir des flancs latéraux de la couche tampon 300. Selon un mode de réalisation, la croissance est épitaxiale en phase vapeur (de type CVD pour « chemical vapor deposition » ou « VPE » pour « vapor phase epitaxy », en anglais), ou par jet moléculaire (MBE).

Dans le cas d'une hétéro-épitaxie, la couche épitaxiée 500 peut être en accord de maille ou en désaccord de maille, par exemple un désaccord inférieur ou égal à 1%, avec la couche à partir de laquelle elle a été formée, c'est-à-dire dans le cas présent, la couche tampon 300. La croissance s'effectue avantageusement monocouche par monocouche. Dans le cas de l'hétéro-épitaxie, le désaccord de réseau (« mismatch » ou « misfit » en anglais), c'est-à-dire la différence entre les paramètres de maille de la couche tampon 300 et ceux de la couche épitaxiale 500, peut entraîner des défauts dans la structure de ce dernier si son épaisseur est telle que l'énergie élastique qu'elle renferme (du fait de sa déformation) est supérieure à l'énergie permettant la création d'un défaut cristallin. Dans un premier temps, les atomes déposés s'adaptent à la structure cristalline de la couche tampon 300. Mais, lorsque l'épaisseur de la couche épitaxiale 500 formée augmente, les propriétés chimiques de ses éléments l'emportent sur celles de la couche tampon 300: les atomes choisissent la structure du matériau pur, ce qui pourrait déformer la structure cristalline de la couche épitaxiée 500 et entraîner la création de dislocations 50. Afin d'éviter ces désagréments, le matériau de la couche épitaxiale 500 présente avantageusement une structure cristalline, un paramètre de maille et une épaisseur qui le rendent apte à la croissance sans défauts sur la couche tampon 300.

Suite à cette croissance épitaxiale, la couche épitaxiale 500 possède une épaisseur, mesurée selon une direction perpendiculaire aux flancs de la couche tampon 300 (donc selon la direction X), comprise entre 5 et 150 nm, de préférence de l'ordre de 10 nm.

La couche épitaxiale 500 est formée en un deuxième matériau différent du premier matériau du substrat 100. Selon des exemples non limitatifs, les matériaux de la couche tampon 300 et de la couche épitaxiale 500 peuvent être choisis parmi les combinaisons suivantes (interchangeables), présentant des matériaux dont les paramètres de maille sont proches: un alliage de germanium-silicium (Si-Ge) avec du silicium (Si), un alliage de silicium-germanium-étain (Si-Ge-Sn) avec du silicium-germanium (SiGe), de l'arséniure de gallium (GaAs) avec du germanium (Ge), de l'arséniure d'indium-gallium (InGaAs) avec du phosphure d'indium (InP), du nitrure de gallium (GaN) avec du nitrure d'aluminium (AIN).

Préférentiellement, le matériau de la couche de masquage restante 200, 201 est compatible avec la croissance sélective du matériau de la couche épitaxiale 500 par rapport au matériau de la couche tampon 300. Le matériau de la couche de masquage 200, 201, est avantageusement conformé de sorte à résister aux attaques chimiques mises en oeuvre au cours de la réalisation du dispositif.

Avantageusement, le mode de réalisation précédemment décrit ne dépend donc pas du rapport de vitesse de croissance latérale et verticale de la couche tampon 300. L'épitaxie de cette couche tampon 300 est, en effet, entièrement confinée selon les flancs d'une tranchée 250 formée dans la couche de masquage 200.

Comme indiqué précédemment, les défauts cristallins sont piégés dans une partie inférieure de la couche tampon 30, c'est-à-dire au sein d'une partie de la couche tampon qui ne forme pas saillie au-delà de la couche de masquage 200. En revanche, une partie supérieure de la couche tampon 300, plus éloignée du substrat 100 que la portion inférieure, sera elle exempte ou pratiquement exempte de défauts cristallins et dislocations. Cette partie supérieure s'étend, pour partie au moins au-delà de la couche de masquage 200 et à partir de la partie inférieure. Comme c'est sur la base de cette partie supérieure que la croissance épitaxiale de la couche 500 est effectuée, cette dernière est également exempte ou pratiquement exempte de défauts cristallins et dislocations.

Bien que le mode de réalisation illustré prévoie une couche de masquage 200 formée de deux couches 201 et 202, on pourra prévoir un nombre de couches plus élevé. Dans un mode de réalisation non compris dans l'invention revendiquée, on pourra prévoir une couche de masquage 200 formée d'une seule couche. Dans ce cas, l'arrêt de la gravure de la couche de masquage 200 lors du retrait partiel pour laisser dépasser la couche tampon 300 s'effectue en contrôlant le temps de gravure.

Les **figures 3a** à **3f** illustrent une autre alternative du procédé de réalisation du dispositif non compris dans l'invention revendiquée. Cette autre approche repose sur une croissance particulière de la couche tampon 300 dans des tranchées 250 selon des conditions qui permettent d'obtenir une vitesse de croissance verticale (c'est-à-dire selon un plan orthogonal à la surface du substrat 100, donc selon la direction Y) supérieure à la vitesse de croissance latérale (c'est-à-dire selon un plan parallèle à la surface du substrat 100, donc selon la direction X). Dans ces conditions, il est possible de faire croître une épaisseur (selon une direction orthogonale à la surface du substrat 100, donc selon la direction Y) de la couche tampon 300 supérieure à la profondeur (selon une direction orthogonale à la surface du substrat 100, donc selon la direction Y) de la tranchée 250, par exemple pour présenter une structure de type ailette (en anglais « FIN »).

La **figure 3a** illustre la formation de la couche de masquage 200 sur le substrat 100. Cette couche de masquage 200 a avantageusement pour fonction de localiser la formation de la couche tampon 300 ainsi que de confiner les défauts cristallins transversaux de la couche tampon 300.

La **figure 3b** illustre la formation de tranchées 250 dans la couche de masquage 200. La formation des tranchées 250 nécessite de recourir, par exemple, à des étapes de photolithographie et de gravure.

La largeur des tranchées 250 est liée à l'épaisseur de la couche de masquage 200 en cela que le rapport de ces deux dimensions (c'est-à-dire le rapport de forme) doit être suffisant pour garantir le confinement des défauts cristallins transversaux de la couche tampon 300 le long des flancs de la couche de masquage 200. Il a été observé que la croissance de la couche tampon 300 de germanium dans les tranchées 250 formées dans la couche de masquage 200 d'oxyde de silicium (SiO₂) est réalisée pour des rapports de forme supérieurs à 1. Ainsi, l'épaisseur (mesurée selon la direction Y) de la couche de masquage 200 est au moins égale à la largeur (mesurée selon la direction X) des tranchées 250.

La **figure 3c** illustre la formation de la couche tampon 300. De préférence, la formation de cette couche comprend une croissance épitaxiale (de type CVD, MBE) de ladite couche à partir du substrat 100 de manière anisotrope. Dans ce cas, la croissance de la couche tampon 300 selon un plan orthogonal à la surface du substrat 100 est avantageusement plus rapide que la croissance de ladite couche selon un plan parallèle à la surface du substrat 100. Avantageusement, l'anisotropie de la croissance selon un plan orthogonal à la surface du substrat 100 permet de garantir la formation de la couche épitaxiale sous forme d'ailette (en anglais « fin »). Dans ce mode de réalisation, le substrat 100 est choisi de sorte que les plans cristallins favorisent la formation (de manière plus précise, la croissance) de la couche tampon 300.

Dans ce mode particulier de réalisation, il n'est plus nécessaire d'utiliser un empilement de couches 201, 202 pour la couche de masquage 200 car la croissance de la couche tampon 300 se fait avantageusement de façon anisotrope ; la croissance horizontale selon un plan parallèle à la surface du substrat 100 étant dominante par rapport à la croissance verticale (selon un plan orthogonal à la surface du substrat 100).

La formation de la couche tampon 300 est opérée de sorte à ce que la couche tampon 300 forme avantageusement saillie au-delà de la couche de masquage 200 laissant à découvert au moins sa face supérieure, s'étendant selon un plan parallèle à la surface du substrat 100, et une partie de ses flancs latéraux ; lesdits flancs latéraux s'étendant selon un plan orthogonal à la surface du substrat 100.

Avantageusement, la hauteur (mesurée selon une direction orthogonale à la surface du substrat) de la partie de la couche tampon 300 faisant saillie au-delà de la couche de masquage 200 est de l'ordre de 10 à 200 nanomètres et est relative à la technique de croissance utilisée pour former la couche tampon 300.

La **figure 3d** illustre la formation d'une couche de protection 400 sur au moins la face supérieure de la couche tampon 300.

Le matériau de la couche de protection 400 est préférentiellement isolant électriquement. De préférence, la formation d'une couche de protection 400 comprend un dépôt pleine plaque suivi d'un retrait de la couche de protection 400 sélectif par rapport au matériau de la couche tampon 300 et au matériau de la couche de masquage 200. Le retrait peut être effectué en utilisant les mêmes moyens que ceux énoncés dans la figure 2e. A titre préféré, la formation de la couche de protection 400 doit être non uniforme sur la surface. En particulier, l'épaisseur de la couche de protection 400 formée sur les flancs latéraux de la couche tampon 300 est inférieure à l'épaisseur de ladite couche sur la face supérieure de la couche tampon et sur la couche de masquage 200. Selon un mode de réalisation préférentiel, la formation de la couche de protection 400 est réalisée par pulvérisation.

La **figure 3e** illustre le retrait partiel de la couche de protection 400 de façon à exposer les flancs latéraux de la couche tampon 300. A titre préféré, ce retrait partiel comprend une gravure par exemple réalisée au moyen d'une solution aqueuse d'acide fluorhydrique dans le cas du retrait d'une couche 400 en oxyde de silicium. Cette gravure est préférentiellement réalisée de manière isotrope et limitée dans le temps de manière à retirer toute l'épaisseur de la couche de protection 400 sur les flancs de la couche tampon 300 et à en conserver sur le sommet de cette dernière.

La **figure 3f** illustre la formation de la couche épitaxiale 500 à partir de la couche tampon 300. Avantageusement, la couche épitaxiale 500 est réalisée à partir d'une croissance épitaxiale, de façon latérale sur les flancs latéraux de la couche tampon 300 ; technique similaire à celle décrite dans la figure 2f.
Selon des exemples non limitatifs, les matériaux de la couche tampon 300 et de la couche épitaxiale 500 peuvent être choisis parmi les combinaisons suivantes (interchangeables) : un alliage de germanium-silicium (Si-Ge) avec du silicium (Si), de l'arséniure de gallium (GaAs) avec du germanium (Ge), de l'arséniure d'indium-gallium (nGaAs) avec du phosphure d'indium (InP), du nitrure de gallium (GaN) avec du nitrure d'aluminium (Aln).
Les matériaux de la couche tampon 300 et de la couche épitaxiale 500 peuvent être de structure cristalline identique mais de paramètres de maille différents. Dans ce cas, le matériau de la couche épitaxiale 500 sera contraint si son épaisseur est limitée afin d'éviter toute relaxation élastique.
La couche épitaxiale 500 réalisée selon le procédé de l'invention forme par exemple un canal dont la largeur, s'étendant selon une direction orthogonale aux flancs latéraux de la couche tampon 300, correspond à l'épaisseur de la couche épitaxiale et dont la profondeur correspond à la hauteur de la couche tampon 300 formant saillie au-delà de la couche de masquage 200, 201. De manière particulièrement avantageuse, le canal est formé en un deuxième matériau, de préférence, différent du premier matériau du substrat 100.
Selon un mode de réalisation particulier, la croissance latérale de la couche épitaxiale 500 peut être suivie d'une croissance latérale d'une couche tampon 300 suivie d'une autre croissance latérale de la couche épitaxiale 500, de sorte à obtenir plusieurs paires de canaux de la couche épitaxiale 500; de préférence, les canaux seront formés en des matériaux différents.

La présente invention permet avantageusement de réaliser des couches de matériaux cristallins sans dislocations 50 et par exemple des canaux contraints sans dislocations. Pour des canaux contraints de silicium, par exemple, on pourra utiliser du silicium-germanium (SiGe) pour la couche tampon 300 afin de faire croître une couche épitaxiale 500 à base de silicium en tension. Dans un autre exemple, pour obtenir des canaux contraints de silicium, on pourra utiliser par exemple du carbure de silicium (SiC) pour la couche tampon 300 afin de faire croître une couche épitaxiale 500 à base de silicium en compression. Selon un autre mode de réalisation, pour obtenir des canaux en silicium-germanium (SiGe) en compression, on pourra utiliser, pour la couche tampon 300, du germanium relaxé.

Avantageusement, le matériau de la couche tampon 300 peut être choisi à grand gap, c'est-à-dire à grande bande interdite (autrement dit de préférence de l'ordre de 1.5eV de plus que le gap du matériau de la couche 500), de sorte à confiner la conduction du matériau de la couche épitaxiale 500 sans circulation de courant dans le matériau de la couche tampon 300.

Selon un mode de réalisation préférentiel, les matériaux de la couche tampon 300 et de la couche épitaxiale 500 peuvent être choisis de manière à faciliter la réalisation d'électrodes de contact.

Les figures 4a et 4b illustrent un mode de réalisation préféré permettant la formation d'un dispositif comprend un transistor de type FinFET, réalisé à partir d'une couche formée selon la procédé de l'invention. FinFET est l'acronyme en anglais de « Fin-Shaped Field Effect Transistor », Fin étant utilisé ici en rapport avec la forme que donne l'architecture de ces transistors au drain et à la source, qui ressemblent alors à des ailerons ou aillettes. Cette appellation désigne des transistors que l'on appelle également "transitors 3D" qui, contrairement aux transistors classiques, se développent dans les 3 dimensions. Ces transistors sont composés de trois éléments : le drain, la source et la grille, avec un canal qui relie la source et le drain. La gravure FinFET des transistors permet de réduire avantageusement d'environ 50% (selon les procédés) les fuites de courant devenues problématiques à mesure que la gravure des processeurs s'est affinée. Autre intérêt des transistors FinFET, ils occupent une surface plus petite puisqu'ils sont aussi construits en hauteur, ce qui leur permet enfin de commuter plus rapidement.

Pour réaliser de tels transistors FinFET à partir du procédé selon l'invention, après la formation de la couche épitaxiale 500 à partir de la partie supérieure des flancs latéraux de la couche tampon 300, on procède au retrait partiel de ladite couche tampon 300 de la région en contact avec les canaux formés 525, 575, de part et d'autre de la couche tampon 300, par la couche épitaxiale 500, tel qu'illustré en **figure 4a****.** Le retrait partiel de la couche tampon 300 peut être réalisé par gravure, de préférence anisotrope, de la couche tampon 300. Une fois la gravure effectuée, on procède au dépôt d'une couche destinée à former une grille 600 sur une partie des ailettes de la couche épitaxiale 500. L'ailette forme en partie au moins un canal 525, 575.
La grille 600 est avantageusement configurée de sorte à contacter chacune des ailettes ou canaux 525, 575 de la couche épitaxiale 500. Selon un autre mode de réalisation, on réalise préalablement une première grille (dite grille « postiche ») et on retire par la suite la couche tampon 300 dans un procédé de type « gate last ».

Après la formation de la couche de la grille 300, on réalise sur une partie des ailettes et sur au moins un canal 525, 575 de la couche épitaxiale 500 non recouverte par la grille 300, des contacts destinés à former des source et drain au niveau de ladite couche épitaxiale 500, comme illustré en **figure 4b****.**

Selon l'invention, chaque couche épitaxiale 500 forme au moins un canal 525, 575 d'un transistor, de préférence de type FinFET. Selon un mode de réalisation non compris dans l'invention revendiquée, on forme un canal 525, 575 sur l'un seulement des flancs latéraux de la couche tampon. A titre préféré, on forme un premier canal 525 sur un premier flanc latéral de la couche tampon 300 et un deuxième canal 575 sur un autre flanc latéral de la couche tampon 300, formant ainsi une paire de canaux 525, 575 à partir d'une même couche tampon 300. La formation de paires de canaux 525, 575 apporte un avantage en termes de densité (deux fois plus de canaux 525, 575 formés). Cela permet de former des structures verticales avec peu de limitations en termes de densité. Selon l'invention, les canaux 525, 575 sont isolés électriquement.

De manière particulièrement avantageuse, le procédé selon la présente invention permet de réaliser un dispositif présentant au moins un canal 525, 575 défini par (hétéro-)épitaxie. Avantageusement, l'au moins un canal 525, 575 forme un canal 525, 575 mince grâce à une croissance latérale contrôlée ; la ligne formée par ledit canal 525, 575 étant, de ce fait, mieux contrôlée en épaisseur et présentant moins de rugosité.

Selon un mode de réalisation, la couche tampon 300 peut comprendre une couche d'arrêt de sorte à ce que le retrait de la couche tampon 300 puisse être stoppé par ladite couche d'arrêt. Préférentiellement, la couche d'arrêt comprend un matériau différent de celui utilisé pour la couche tampon 300.

La couche de protection 400 formée sur la face supérieure de la couche tampon 300 afin d'empêcher une éventuelle croissance de la couche épitaxiale 500 sur la face supérieure, peut être retirée localement dans le but de former un pontage entre les zones épitaxiées de la couche épitaxiale 500 formées de part et d'autre de la couche tampon 300. Cela peut être avantageux afin de réaliser une connexion entre deux ailettes conductrices ou semi-conductrices séparées par une couche tampon 300 isolante électriquement.

La couche épitaxiale 500 peut comprendre un empilement de couches, par exemple, dans le cas d'une couche épitaxiale de canal de type III-V nécessitant un revêtement (en anglais « capping layer ») épitaxial avant le dépôt de l'empilement de grille. Ce mode de réalisation permet d'éloigner les porteurs de charge qui parcourent la couche épitaxiale 500 de la surface de l'isolant de grille, et également de préserver leur mobilité.

Avantageusement, on peut combiner une multitude de matériaux pour la couche tampon 300 et la couche épitaxiale 500 de manière à offrir simultanément sur le même substrat 100 des caractéristiques diverses. En particulier, selon un mode de réalisation, on réalise sur le même substrat 100 des dispositifs à canaux de type n et p. Par exemple, le matériau de la couche épitaxiale 500 peut être choisi parmi le silicium ou l'arséniure d'indium-gallium (InGaAs) (contraints ou pas) pour former le canal de type n tandis que le matériau de la couche tampon 300 pourra être du silicium-germanium (SiGe) (contraint ou pas) pour former le canal de type n. Selon un autre exemple de configuration, en variant la composition du silicium-germanium (SiGe), on réalise des dispositifs dont la tension de seuil diffère.

La présente invention permet également de réaliser sur un même substrat 100 des dispositifs de nature différente tels que, par exemple, des transistors à effet de champ de type FinFET (acronyme de l'anglais « Fin Field-Effect Transistor ») combinés à des transistors de type laser. Dans le cas du transistor laser, l'architecture spécifique d'un tel transistor offre la possibilité d'obtenir du germanium en tension comprenant un dopage de type n conformé de sorte à réaliser un transistor laser de type germanium sur silicium.

Comme cela apparaît clairement au vu de la description qui précède, l'invention permet ainsi de recourir au principe de confinement des dislocations 50 sur un matériau autre que celui du canal.

En outre, l'invention a pour avantage de limiter les contraintes imposées par le principe de confinement des dislocations 50. La croissance de la couche épitaxiale 500 à partir des flancs latéraux de la couche tampon 300 n'est avantageusement pas affectée par les défauts cristallins longitudinaux se développant dans la couche tampon 300 lors de sa formation à partir du substrat 100.

D'autre part et de manière particulièrement avantageuse, la densité de motifs ou canaux de la couche épitaxiale 500 obtenus à partir du procédé selon l'invention est au moins équivalente au double de la densité de motifs pouvant être obtenus en recourant à des étapes de photolithographie. D'autre part, la largeur (selon un plan parallèle à la surface du substrat 100) et la rugosité des canaux 525, 575 hétéro-épitaxiés de la couche épitaxiale 500 sont uniquement déterminées par la croissance de ladite couche épitaxiale 500. Avantageusement, les canaux 525, 575 hétéro-épitaxiés sont formés dans des matériaux différents de celui du substrat 100.

L'invention n'est pas limitée aux modes de réalisation précédemment décrits et s'étend à tous les modes de réalisation couverts par les revendications.

## Revendications

1. Procédé de réalisation d'une couche cristalline à partir d'un substrat (100) cristallin en un premier matériau; le procédé comprenant les étapes suivantes :
- dépôt d'une couche de masquage (200) sur le substrat (100), la couche de masquage (200) étant formée d'un empilement de couches (201, 202) dont les matériaux diffèrent d'une couche à l'autre et sont configurés de sorte à être retirés sélectivement les uns par rapport aux autres, la couche de masquage (200) comprenant une première couche (201) formant une couche d'arrêt surmontée d'au moins une deuxième couche (202),
- formation, par gravure de la couche de masquage (200), d'au moins une tranchée (250) dans la couche de masquage (200), la tranchée (250) formant un accès au substrat (100), la formation de la tranchée (250) étant réalisée de sorte que la tranchée (250) présente une profondeur au moins égale à une valeur Hc telle que Hc= K.S.tan(θ) où K est au moins supérieur à 0.7, S est la largeur de la tranchée (250) et θ est l'angle formé par un plan dans lequel s'étend principalement le substrat (100) et des dislocations du matériau de la couche tampon (300) situé dans la tranchée (250),
- formation d'une couche tampon (300) cristalline située en partie au moins dans la tranchée (250) de la couche de masquage (200), s'étendant depuis le substrat (100) et formant saillie au-delà de la première couche (201) de la couche de masquage (200) de sorte à ce qu'une partie supérieure des flancs latéraux de ladite couche tampon (300) soit laissée à découvert, l'étape de formation comprenant une croissance de la couche tampon (300) à partir du substrat (100) cristallin de manière à donner à la couche tampon (300) une structure cristalline en utilisant la structure cristalline du substrat (100) cristallin, la formation de la couche tampon (300) comprenant, après la croissance de la couche tampon (300) à partir du substrat (100), une étape de retrait d'une partie de la couche de masquage (200) de sorte à découvrir ladite partie supérieure des flancs latéraux de la couche tampon (300), l'étape de retrait d'une partie de la couche de masquage (200) étant effectuée par gravure de la deuxième couche (202) avec arrêt sur la première couche (201),
- formation d'une couche épitaxiale (500) cristalline en un deuxième matériau, différent du matériau de la couche tampon (300), par croissance à partir de ladite partie supérieure des flancs latéraux de la couche tampon (300) laissée à découvert, le matériau de la couche tampon (300) et le matériau de la couche épitaxiale (500) présentant un désaccord de paramètre de maille inférieur à 2%, la formation de la couche tampon (300) étant effectuée de manière à laisser à découvert une face supérieure de la couche tampon (300) en plus de ladite partie supérieure des flancs latéraux de la couche tampon (300), préalablement à la formation de la couche épitaxiale (500), formation d'une couche de protection (400) sur ladite face supérieure de la couche tampon (300) de sorte à laisser découvert uniquement ladite partie supérieure des flancs latéraux de la couche tampon (300) laissée à découvert, et, après la formation de la couche épitaxiale (500) de part et d'autre de la couche tampon (300), retrait de la couche tampon (300) sélectivement à la couche épitaxiale (500) de manière à laisser en place un premier canal (525) et un deuxième canal (575) formés par la couche épitaxiale (500) ; lesdits premier et deuxième canaux (525, 575) étant isolés électriquement et formant chacun un canal de transistor de préférence de type FinFET.

2. Procédé selon la revendication précédente dans lequel la croissance de la couche tampon (300) comprend une croissance épitaxiale à partir du substrat (100) ou dans lequel la croissance de la couche tampon (300) comprend un dépôt de ladite couche (300), suivi d'un recuit de cristallisation.

3. Procédé selon l'une quelconque des revendications précédentes dans lequel la couche de masquage (200) est choisie de manière à empêcher la croissance de la couche épitaxiale (500) à partir de la couche de masquage (200).

4. Procédé selon l'une quelconque des revendications précédentes dans lequel la couche de protection (400) est choisie de manière à empêcher la croissance de la couche épitaxiale (500) à partir de la couche de protection (400).

5. Procédé selon l'une quelconque des revendications précédentes dans lequel la formation de la couche épitaxiale (500) comprend une croissance épitaxiale à partir de la partie supérieure des flancs latéraux de la couche tampon (300) laissée à découvert ; la formation de la couche épitaxiale (500) comprenant une croissance anisotrope dirigée perpendiculairement aux flancs latéraux de la couche tampon (300) laissée à découvert.

6. Procédé selon l'une quelconque des revendications 1 à 4 dans lequel la formation de la couche épitaxiale (500) comprend un dépôt de matériau amorphe suivi d'une étape de recuit de cristallisation dudit matériau.

7. Procédé selon l'une quelconque des revendications précédentes dans lequel.la croissance de la couche tampon (300) à partir du substrat (100) est effectuée de manière à ce que le sommet de la couche tampon (300) ne forme pas saillie au-delà de la couche de masquage (200) avant l'étape de retrait d'une partie de la couche de masquage (200) et forme saillie au-delà de la couche de masquage (200) après l'étape de retrait d'une partie de la couche de masquage (200).

8. Procédé selon l'une quelconque des revendications précédentes dans lequel l'étape de retrait d'une partie de la couche de masquage (200) est effectuée par gravure, dans lequel préalablement à l'étape de retrait d'une partie de la couche de masquage (200), on réalise la formation d'une couche de protection (400) sur la face supérieure de la couche tampon (300) et dans lequel la gravure de la couche de masquage (200) grave la couche de masquage (200) sélectivement à la couche de protection (400) et à la couche tampon (300) et dans lequel on conserve la couche de protection (400) lors de la formation de la couche épitaxiale (500).

9. Procédé selon l'une quelconque des revendications 1 à 6 dans lequel la croissance de la couche tampon (300) à partir du substrat (100) est poursuivie jusqu'à ce que la couche tampon (300) forme saillie au-delà de la couche de masquage (200).

10. Procédé selon la revendication précédente dans lequel la formation d'une couche de protection (400) sur ladite face supérieure de la couche tampon (300) comprend :
- le dépôt d'une couche de protection (400) sur le dispositif ;
- le retrait de la totalité de la couche de protection (400) sur les flancs latéraux de la couche tampon (300) tout en conservant une partie au moins de la couche de protection (400) sur la couche de masquage (200) et sur ladite face supérieure de la couche tampon (300);
- le retrait de la couche de protection (400) sur la couche de masquage (200) en laissant en place la couche de protection (400) sur ladite face supérieure de la couche tampon (300).

11. Procédé selon l'une quelconque des revendications précédentes dans lequel K est supérieur à 0.8 et de préférence supérieur ou égal à 1.

12. Procédé selon l'une quelconque des revendications précédentes dans lequel la couche tampon (300) est faite d'un matériau différent de celui du substrat (100).

13. Procédé selon la revendication précédente dans lequel le matériau de la couche tampon (300) et le matériau du substrat (100) présentent un désaccord de maille inférieur à 10%.

## Patentansprüche

1. Verfahren zur Herstellung einer kristallinen Schicht, ausgehend von einem kristallinen Substrat (100) aus einem ersten Material;
wobei das Verfahren die folgenden Schritte umfasst:
- Abscheidung einer Abschirmungsschicht (200) auf dem Substrat (100), wobei die Abschirmungsschicht (200) aus einem Stapel von Schichten (201, 202) gebildet ist, deren Materialien sich von einer Schicht zur anderen unterscheiden und so konfiguriert sind, dass sie selektiv relativ zueinander entfernt werden, wobei die Abschirmungsschicht (200) eine erste Schicht (201) umfasst, die eine Sperrschicht bildet, die von mindestens einer zweiten Schicht (202) bedeckt ist,
- Bildung, durch Ätzen der Abschirmungsschicht (200), von mindestens einer Schneise (250) in der Abschirmungsschicht (200), wobei die Schneise (250) einen Zugang zum Substrat (100) bildet, wobei die Bildung der Schneise (250) so durchgeführt wird, dass die Schneise (250) eine Tiefe aufweist, die mindestens einem Wert Hc entspricht, so dass Hc = K.S.tan(θ) ist, wobei K mindestens größer als 0,7 ist, S die Breite der Schneise (250) ist und θ der Winkel ist, der durch eine Ebene gebildet wird, in der sich das Substrat (100) grundsätzlich erstreckt, und Versetzungen des Materials der Pufferschicht (300), das sich in der Schneise (250) befindet,
- Bildung einer kristallinen Pufferschicht (300), die sich mindestens teilweise in der Schneise (250) der Abschirmungsschicht (200) befindet, die sich vom Substrat (100) aus erstreckt, und einen Vorsprung bildet, der über die erste Schicht (201) der Abschirmungsschicht (200) hinausragt, so dass ein oberer Teil der seitlichen Flanken der Pufferschicht (300) freigelegt bleibt, wobei der Bildungsschritt ein Wachstum der Pufferschicht (300) ausgehend vom kristallinen Substrat (100) umfasst, um der Pufferschicht (300) unter Verwendung der kristallinen Struktur des kristallinen Substrats (100) eine kristalline Struktur zu verleihen, wobei die Bildung der Pufferschicht (300), nach dem Wachstum der Pufferschicht (300) ausgehend vom Substrat (100), einen Schritt des Entfernens eines Teils der Abschirmungsschicht (200) umfasst, um den oberen Teil der seitlichen Flanken der Pufferschicht (300) freizulegen, wobei der Schritt des Entfernens eines Teils der Abschirmungsschicht (200) durch Ätzen der zweiten Schicht (202) mit Sperren auf der ersten Schicht (201) erfolgt,
- Bildung einer epitaktischen kristallinen Schicht (500) aus einem zweiten Material, das sich vom Material der Pufferschicht (300) unterscheidet, durch Wachstum ausgehend vom oberen Teil der seitlichen Flanken der Pufferschicht (300), der freigelegt geblieben ist, wobei das Material der Pufferschicht (300) und das Material der epitaktischen Schicht (500) eine Diskrepanz des Maschenparameters von weniger als 2 % aufweisen,
wobei die Bildung der Pufferschicht (300) so erfolgt, dass zusätzlich zum oberen Teil der seitlichen Flanken der Pufferschicht (300), vor der Bildung der epitaktischen Schicht (500), eine obere Fläche der Pufferschicht (300) freigelegt bleibt, wobei eine Schutzschicht (400) auf der oberen Fläche der Pufferschicht (300) so gebildet wird, dass nur der obere Teil der seitlichen Flanken der Pufferschicht (300), die freigelegt geblieben ist, freigelegt bleibt, und, nach der Bildung der epitaktischen Schicht (500) auf beiden Seiten der Pufferschicht (300), Entfernen der Pufferschicht (300) selektiv zur epitaktischen Schicht (500), so dass ein erster Kanal (525) und ein zweiter Kanal (575), die durch die epitaktische Schicht (500) gebildet werden, verbleiben;
wobei der erste und der zweite Kanal (525, 575) elektrisch isoliert sind und jeweils einen Transistorkanal bilden, vorzugsweise vom Typ FinFET.

2. Verfahren nach dem vorhergehenden Anspruch, wobei das Wachstum der Pufferschicht (300) ein epitaktisches Wachstum ausgehend vom Substrat (100) umfasst oder wobei das Wachstum der Pufferschicht (300) eine Abscheidung der Schicht (300) umfasst, gefolgt von einem Kristallisationsglühen.

3. Verfahren nach einem der vorhergehenden Ansprüche, wobei die Abschirmungsschicht (200) so gewählt ist, dass das Wachstum der epitaktischen Schicht (500) ausgehend von der Abschirmungsschicht (200) verhindert wird.

4. Verfahren nach einem der vorhergehenden Ansprüche, wobei die Schutzschicht (400) so gewählt ist, dass das Wachstum der epitaktischen Schicht (500) ausgehend von der Schutzschicht (400) verhindert wird.

5. Verfahren nach einem der vorhergehenden Ansprüche, wobei die Bildung der epitaktischen Schicht (500) ein epitaktisches Wachstum ausgehend vom oberen Teil der seitlichen Flanken der Pufferschicht (300), die freigelegt geblieben sind, umfasst; wobei die Bildung der epitaktischen Schicht (500) ein anisotropes Wachstum umfasst, das perpendikular zu den seitlichen Flanken der Pufferschicht (300), die freigelegt geblieben sind, gerichtet ist.

6. Verfahren nach einem der Ansprüche 1 bis 4, wobei die Bildung der epitaktischen Schicht (500) eine Abscheidung von amorphem Material umfasst, gefolgt von einem Schritt des Kristallisationsglühens des Materials.

7. Verfahren nach einem der vorhergehenden Ansprüche, wobei das Wachstum der Pufferschicht (300) ausgehend vom Substrat (100) so erfolgt, dass der Gipfel der Pufferschicht (300), vor dem Schritt des Entfernens eines Teils der Abschirmungsschicht (200), keinen Vorsprung bildet, der über die Abschirmungsschicht (200) hinausragt, und nach dem Schritt des Entfernens eines Teils der Abschirmungsschicht (200) einen Vorsprung bildet, der über die Abschirmungsschicht (200) hinausragt.

8. Verfahren nach einem der vorhergehenden Ansprüche, wobei der Schritt des Entfernens eines Teils der Abschirmungsschicht (200) durch Ätzen erfolgt, wobei vor dem Schritt des Entfernens eines Teils der Abschirmungsschicht (200) auf der oberen Fläche der Pufferschicht (300) die Bildung einer Schutzschicht (400) durchgeführt wird, und wobei das Ätzen der Abschirmungsschicht (200) die Abschirmungsschicht (200) selektiv an der Schutzschicht (400) und der Pufferschicht (300) ätzt, und wobei die Schutzschicht (400) bei der Bildung der epitaktischen Schicht (500) erhalten bleibt.

9. Verfahren nach einem der Ansprüche 1 bis 6, wobei das Wachstum der Pufferschicht (300) ausgehend vom Substrat (100) fortgesetzt wird, bis die Pufferschicht (300) einen Vorsprung bildet, der über die Abschirmungsschicht (200) hinausragt.

10. Verfahren nach dem vorhergehenden Anspruch, wobei die Bildung einer Schutzschicht (400) auf der oberen Fläche der Pufferschicht (300) umfasst:
- die Abscheidung einer Schutzschicht (400) auf der Vorrichtung;
- das Entfernen der gesamten Schutzschicht (400) an den seitlichen Flanken der Pufferschicht (300) unter Erhaltung mindestens eines Teils der Schutzschicht (400) auf der Abschirmungsschicht (200) und auf der oberen Fläche der Pufferschicht (300);
- das Entfernen der Schutzschicht (400) auf der Abschirmungsschicht (200), wobei die Schutzschicht (400) auf der oberen Fläche der Pufferschicht (300) verbleibt.

11. Verfahren nach einem der vorhergehenden Ansprüche, wobei K größer als 0,8 ist und vorzugsweise größer oder gleich 1.

12. Verfahren nach einem der vorhergehenden Ansprüche, wobei die Pufferschicht (300) aus einem anderen Material als das Substrat (100) besteht.

13. Verfahren nach dem vorhergehenden Anspruch, wobei das Material der Pufferschicht (300) und das Material des Substrats (100) eine Diskrepanz der Maschen von weniger als 10 % aufweisen.

## Claims

1. Method for creating a crystalline layer from a crystalline substrate (100) made of a first material;
the method comprising the following steps:
- depositing a masking layer (200) on the substrate (100), the masking layer (200) being formed by a stack of layers (201, 202), the materials of which differ from one layer to the other and are configured so as to be removed selectively with respect to each other, the masking layer (200) comprising a first layer (201) forming a stop layer above which there is at least a second layer (202),
- forming, by etching of the masking layer (200), at least one trench (250) in the masking layer (200), the trench (250) forming an access to the substrate (100), the formation of the trench (250) being carried out so that the trench (250) has a depth at least equal to a value Hc such that Hc= K.S.tan(θ) where K is at least greater than 0.7, S is the width of the trench (250) and θ is the angle formed by a plane in which the substrate (100) mainly extends and dislocations of the material of the buffer layer (300) located in the trench (250),
- forming a crystalline buffer layer (300) located at least partly in the trench (250) of the masking layer (200), extending from the substrate (100) and forming a protrusion beyond the first layer (201) of the masking layer (200) so that an upper part of the lateral sides of said buffer layer (300) is left exposed, the formation step comprising a growth of the buffer layer (300) from the crystalline substrate (100) so as to give the buffer layer (300) a crystalline structure by using the crystalline structure of the crystalline substrate (100), the formation of the buffer layer (300) comprising, after the growth of the buffer layer (300) from the substrate (100), a step of removing a part of the masking layer (200) so as to expose said upper part of the lateral sides of the buffer layer (300), the step of removing a part of the masking layer (200) being carried out by etching of the second layer (202) with stoppage on the first layer (201),
- forming a crystalline epitaxial layer (500) made of a second material, different from the material of the buffer layer (300), by growth from said upper part of the lateral sides of the buffer layer (300) left exposed, the material of the buffer layer (300) and the material of the epitaxial layer (500) having a difference in mesh parameter of less than 2%, the formation of the buffer layer (300) being carried out so as to leave exposed an upper face of the buffer layer (300) in addition to said upper part of the lateral sides of the buffer layer (300), before the formation of the epitaxial layer (500), forming a protective layer (400) on said upper face of the buffer layer (300) so as to leave exposed only said upper part of the lateral sides of the buffer layer (300) left exposed, and, after the formation of the epitaxial layer (500) on either side of the buffer layer (300), removing the buffer layer (300) selectively with respect to the epitaxial layer (500) so as to leave in place a first channel (525) and a second channel (575) formed by the epitaxial layer (500);
said first and second channel (525, 575) being electrically insulated and each forming a transistor channel preferably of the FinFET type.

2. Method according to the preceding claim, wherein the growth of the buffer layer (300) comprises an epitaxial growth from the substrate (100) or wherein the growth of the buffer layer (300) comprises a deposition of said layer (300), followed by a crystallisation annealing.

3. Method according to any one of the preceding claims, wherein the masking layer (200) is chosen so as to prevent the growth of the epitaxial layer (500) from the masking layer (200).

4. Method according to any one of the preceding claims, wherein the protective layer (400) is chosen so as to prevent the growth of the epitaxial layer (500) from the protective layer (400).

5. Method according to any one of the preceding claims, wherein the formation of the epitaxial layer (500) comprises an epitaxial growth from the upper part of the lateral sides of the buffer layer (300) left exposed, the formation of the epitaxial layer (500) comprising an anisotropic growth directed perpendicularly to the lateral sides of the buffer layer (300) left exposed.

6. Method according to any one of claims 1 to 4, wherein the formation of the epitaxial layer (500) comprises a deposition of amorphous material followed by a step of crystallisation annealing of said material.

7. Method according to any one of the preceding claims, wherein the growth of the buffer layer (300) from the substrate (100) is carried out so that the top of the buffer layer (300) does not form a protrusion beyond the masking layer (200) before the step of removing a part of the masking layer (200) and forms a protrusion beyond the masking layer (200) after the step of removing a part of the masking layer (200).

8. Method according to any one of the preceding claims, wherein the step of removing a part of the masking layer (200) is carried out by etching, wherein before the step of removing a part of the masking layer (200), the formation of a protective layer (400) on the upper face of the buffer layer (300) is carried out and wherein the etching of the masking layer (200) etches the masking layer (200) selectively with respect to the protective layer (400) and the buffer layer (300) and wherein the protective layer (400) is preserved during the formation of the epitaxial layer (500).

9. Method according to any one of claims 1 to 6, wherein the growth of the buffer layer (300) from the substrate (100) is continued until the buffer layer (300) forms a protrusion beyond the masking layer (200).

10. Method according to the preceding claim, wherein the formation of a protective layer (400) on said upper face of the buffer layer (300) comprises:
- the deposition of a protective layer (400) on the device;
- the removal of the totality of the protective layer (400) on the lateral sides of the buffer layer (300) while preserving at least a part of the protective layer (400) on the masking layer (200) and on said upper face of the buffer layer (300);
- the removal of the protective layer (400) on the masking layer (200) while leaving in place the protective layer (400) on said upper face of the buffer layer (300).

11. Method according to any one of the preceding claims, wherein K is greater than 0.8 and preferably greater than or equal to 1.

12. Method according to any one of the preceding claims, wherein the buffer layer (300) is made from a different material than that of the substrate (100).

13. Method according to the preceding claim, wherein the material of the buffer layer (300) and the material of the substrate (100) have a difference in mesh of less than 10%.
